## Europäisches Patentamt

## European Patent Office

## Office européen des brevets

(19)

(11) Veröffentlichungsnummer : **0 046 878**
**B1**

(12) **EUROPÄISCHE PATENTSCHRIFT**

(45) Veröffentlichungstag der Patentschrift :
15.05.85

(21) Anmeldenummer : 81105849.4

(22) Anmeldetag : 24.07.81

(51) Int. Cl.⁴ : **H 03 F  3/45**

(54) **Rückgekoppelter Verstärker oder Schwellwertschalter für eine stromgespeiste Differenzstufe.**

(30) Priorität : 30.08.80 DE 3032703

(43) Veröffentlichungstag der Anmeldung :
10.03.82 Patentblatt 82/10

(45) Bekanntmachung des Hinweises auf die Patenterteilung : 15.05.85 Patentblatt 85/20

(84) Benannte Vertragsstaaten :
FR GB IT NL

(56) Entgegenhaltungen :
DE-A- 2 024 806
FR-A- 1 319 174
GB-A- 2 077 542
PROCEEDINGS OF THE I.E.E.-G, Band 127, Nr. 2,
April 1980, Seiten 61-66 Stevenage, G.B. J. CHOMA:
"Actively peaked broadbanden monolithic amplifier"
IBM TECHNICAL DISCLOSURE BULLETIN, Band 23,
Nr. 1, Juni 1980, Seiten 48-49 New York, U.S.A. V.S.
MOORE et al.: "Differential amplifier gain-bandwidth
circuit with a differentially driven load"

(73) Patentinhaber : TELEFUNKEN electronic GmbH
Theresienstrasse 2
D-7100 Heilbronn (DE)

(72) Erfinder : Böhme, Rolf, Dr.
Sudetenstrasse 1
D-7107 Bad Friedrichshall (DE)

(74) Vertreter : Maute, Hans-Jürgen, Dipl.-Ing. et al
TELEFUNKEN electronic GmbH Theresienstrasse 2
D-7100 Heilbronn (DE)

Jouve, 18, rue St-Denis, 75001 Paris, France

EP 0 046 878 B1

## Beschreibung

Die Erfindung betrifft eine Schaltungsanordnung, die für den Fall, daß das Produkt aus innerer Verstärkung und Rückkopplungsfaktor kleiner als eins ist, als Verstärker und für den Fall, daß das Produkt aus innerer Verstärkung und Rückkopplungsfaktor größer als eins ist, als Schwellwertschalter wirkt, für eine stromgespeiste Differenzstufe, bei der der erste Ausgang der Differenzstufe mit dem Emitter eines ersten Transistors und der zweite Ausgang mit dem Emitter eines zweiten Transistors verbunden ist und bei dem zwei an die Versorgungsspannung angeschlossene Arbeitswiderstände vorgesehen sind, von denen der erste Arbeitswiderstand an den Kollektor des ersten Transistors und die Basis des zweiten Transistors angeschlossen ist und der zweite Arbeitswiderstand an den Kollektor des zweiten Transistors und die Basis des ersten Transistors angeschlossen ist.

Eine derartige Anordnung, die jedoch keinen Hinweis auf die alternative Verwendung als Verstärker oder Schwellwertschalter gibt, ist aus der Literaturstelle « IBM Technical Disclosure Bulletin, Vol. 23, N° 1, Juni 1980, Seiten 48 und 49 », bekannt.

Die FR-A-13 19 174 hat einen Verstärker zum Gegenstand, bei dem durch Mitkopplung die Werte der Arbeitswiderstände dynamisch vergrößert werden können, einschließlich unendlich oder negative Werte. Die bekannte Schaltung ist jedoch relativ aufwendig und durch die kapazitive Kopplung auf Wechselgrößen beschränkt. Bei der bekannten Schaltung wirken die Ausgänge der Differenzverstärkerstransistoren auf die Basen von Rückkoppeltransistoren ein, deren Kollektoren über Kreuz die Rückkopplung herstellen.

Der Erfindung liegt die Aufgabe zugrunde, eine Schaltungsanordnung zur Verwendung als rückgekoppelter Verstärker oder Schwellwertschalter anzugeben, die an einer stromgespeisten Differenzstufe angeschlossen ist, eine vereinfachte Schaltungstechnik und geringe Verlustleistung besitzt und die leicht integrierbar ist. Diese Aufgabe wird bei einer Schaltungsanordnung der eingangs erwähnten Art nach der Erfindung dadurch gelöst, daß ein Widerstand zwischen beide Ausgänge der Differenzstufe geschaltet ist, der beim Verstärker mit sinkendem Widerstandswert zur Erhöhung der Stromverstärkung oder beim Schwellwertschalter zum Einstellen des Abstandes der Umschaltpunkte, bei denen der Strom der Stromquelle von einem der Arbeitswiderstände auf den anderen wechselt, dient.

Die Schaltungsanordnung nach der Erfindung benötigt im Gegensatz zu einem in der DE-B-19 03 913 dargestellten Vorschlag keinen zusätzlichen Versorgungsstrom.

Bei der erfindungsgemäßen Schaltung kann jede beliebige Stromverstärkung von 1 bis unendlich eingestellt werden. Zusätzlich kann diese Schaltung die Funktion eines Schwellwertschalters mit beliebiger Hysterese erfüllen. Gegenüber der in der DE-B-20 24 806 dargestellten Schaltung besitz sie den Vorteil, daß nach dem Eintritt in den Übersteuerungszustand der Ausgangsstrom seinen Sättigungswert beibehält und nicht zum anderen Arbeitswiderstand wechselt.

Gemäß einer Weiterbildung der Erfindung ist die Basis des ersten Transistors über einen Widerstand mit dem Kollektor des zweiten Transistors und die Basis des zweiten Transistors über einen Widerstand mit dem Kollektor des ersten Transistors verbunden. Jeweils zwischen Basis und Emitter des ersten bzw. zweiten Transistors ist ein Widerstand eingefügt.

Eine andere Weiterbildung der Erfindung besteht darin, daß der Basis des ersten Transistors und der Basis des zweiten Transistors je ein als Emitterfolger arbeitender Transistor vorgeschaltet ist. Dies erfolgt im Normalfall so, daß die Basis des ersten Transistors mit dem Emitter des vierten Transistors und die Basis des zweiten Transistors mit dem Emitter des dritten Transistors mit der Versorgungsspannung verbunden sind und daß die Basis des dritten Transistors mit dem Kollektor des ersten Transistors und die Basis des vierten Transistors mit dem Kollektor des zweiten Transistors verbunden sind.

Die Erfindung wird im folgenden an einem Ausführungsbeispiel näher erläutert.

Die Figur 1 zeigt eine Schaltungsanordnung, die als rückgekoppelter Verstärker oder als Schwellwertschalter wirksam ist.

Die Figur 2 zeigt eine Schaltungsanordnung gemäß der Figur 1, bei der die kreuzgekoppelten Transistoren Basisvorwiderstände aufweisen.

Die Figur 3 zeigt eine Schaltungsanordnung gemäß Figur 1, bei der die Basen der kreuzgekoppelten Transistoren über zwei als Emitterfolger arbeitende Transistoren angeschlossen sind.

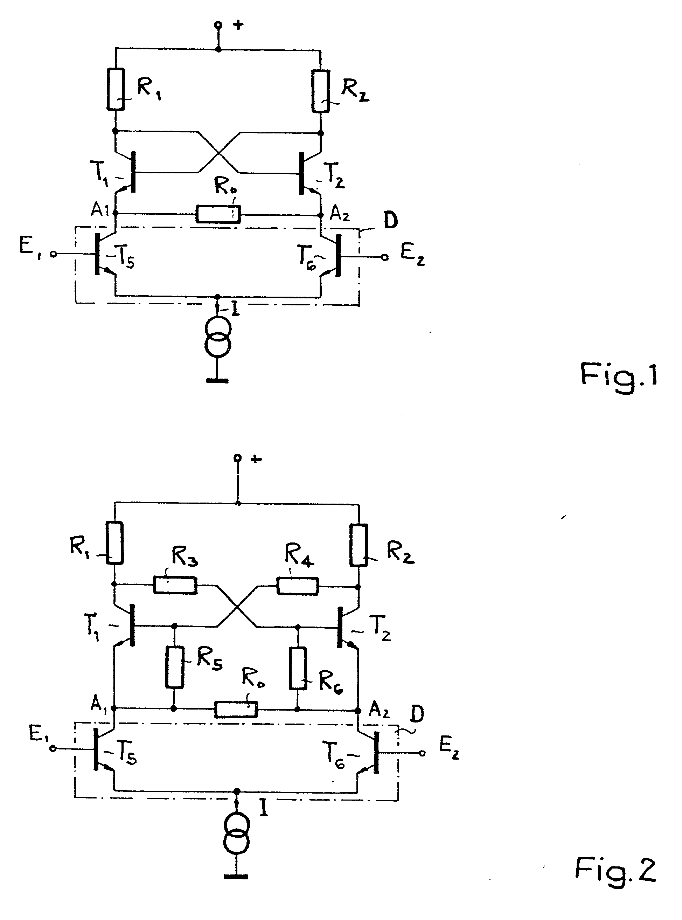

Die Figur 1 zeigt einen rückgekoppelten Verstärker, dessen zugehörige Differenzstufe D beispielsweise aus den bipolaren Transistoren T5 und T6 besteht und die von einer Stromquelle I beliebiger Ausführungsform gespeist wird. Je nach der Differenz der Potentiale an den Eingangsklemmen E1 und E2 und damit an den Basen der Transistoren T5 und T6 wird der Strom der Stromquelle I auf die beiden Ausgänge A1 und A2 an den Kollektoren der Transistoren T5 und T6 aufgeteilt. Ohne R0 zwischen A1 und A2 würden die beiden Teilströme über die Transistoren T1 und T2 nahezu unverändert in die Arbeitswiderstände R1, R2 fließen, soweit die Basisströme der beiden Transistoren T1 und T2 klein bleiben. Steuert man die Differenzstufe D so, daß der Strom im Ausgang A1 stärker und der im Ausgang A2 schwächer wird, so steigt der Spannungsabfall and R1 und sinkt an R2. Durch die Kreuzkopplung der Transistoren T1, T2 werden aber die Spannungsänderungen über die Basis-Emitterstrecken der Transistoren T1 bzw. T2 vertauscht an die Ausgänge A1 und A2 der Differenzstufe D weitergegeben. Während das Potential am Kollektor von T1 sinkt, steigt es am Emitter von T1 an. Der durch R0 fließende Strom addiert sich zum vom Eingangssignal verursachten Strom und führt zur Erhöhung der Stromverstärkung. Ist der Widerstand R0 gleich der Summe der Arbeitswiderstände R1 und R2 minus der Kehrwerte der beiden Transistorsteilheiten, so wird die Verstärkung unendlich. Das bedeutet, daß der Strom der Stromquelle I bei einem bestimmten Wert der zwischen den Eingangsklemmen E1 und E2 wirksamen Eingangsspannung sprunghaft von einem der Arbeitswiderstände R1 bzw. R2 auf den anderen wechselt. Weitere Verminderungen des Widerstandes R0 führt dazu, daß sich der Punkt des Umschaltens des Stromes für steigende Eingangsspannung von dem für fallende Eingangsspannung unterscheidet. Damit ist der Charakter einer Schwellwertschaltung erreicht. Der Abstand der Umschaltpunkte kann durch Wahl von R0 beliebig eingestellt werden.

In der Schaltung nach Fig. 1 ist das Kollektorpotential der Transistoren T1, T2 etwa gleich dem Basispotential. Damit sind nur kleine Aussteuerungen möglich und die Transistoren können leicht in den Sättigungszustand eintreten. Deshalb ist gemäß der Fig. 2 vorgesehen, den Basen des ersten und zweiten Transistors T1 bzw. T2 Widerstände R3 bzw. R4 vorzuschalten. Der Spannungsabfall über diesen Widerständen sorgt für ein gegenüber der Basis erhöhtes Kollektorpotential. Zwei weitere Widerstände R5 und R6, die jeweils zwischen Basis und Emitter des ersten und zweiten Transistors T1 bzw. T2 geschaltet sind, bilden mit den Widerständen R3 und R4 Spannungsteiler, mit denen die Arbeitspunkte des ersten und zweiten Transistors T1 bzw. T2 optimal festgelegt werden können.

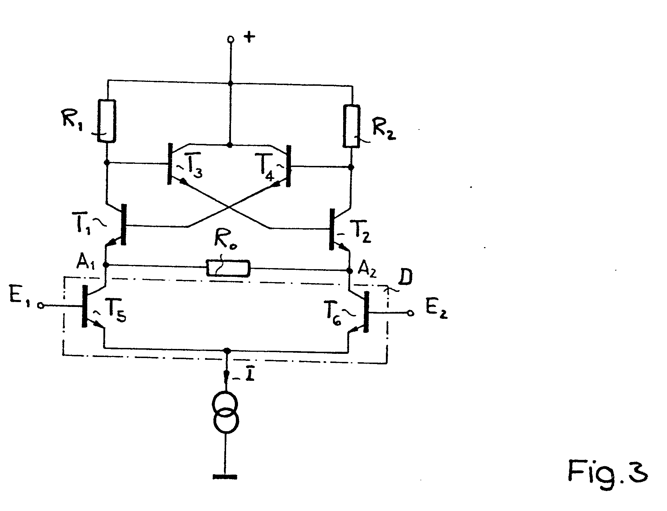

Die Schaltungsanordnung der Fig. 3 unterscheidet sich von der Schaltungsanordnung der Fig. 1 dadurch, daß die Basen der Transistoren T1 und T2 über zwei als Emitterfolger arbeitende Transistoren T3 und T4 angeschlossen sind. Wie die Fig. 3 zeigt, ist der erste Emitterfolger T3 mit der Basis am Kollektor des Transistors T1 und mit dem Emitter an der Basis des Transistors T2, der zweite Emitterfolger T4 mit der Basis am Kollektor des Transistors T2 und mit dem Emitter an der Basis des Transistors T1 angeschlossen. Die Kollektoren der Transistoren T3 und T4 sind mit der Versorgungsspannung verbunden. Zusätzlich können auch die in Fig. 3 nicht eingezeichneten Widerstände R5 und R6 in der Anordnung nach Fig. 2 vorhanden sein. In dieser Form der Erfindung ist das Ruhepotential der Kollektoren der Transistoren T1 und T2 um die Basis-Emitter-Spannung der Transistoren T3 und T4 höher und es sind dadurch entsprechend größere Aussteuerungen möglich.

Die ausschließliche Verwendung von npn-Transistoren ergibt günstige elektrische und konstruktive Bedingungen für die Realisierung als monolithisch integrierter Halbleiterblock. Die Verwendung von pnp-Transistoren bei Umkehrung aller Spannungen und Ströme ist ebensogut möglich.

## Patentansprüche

1. Schaltungsanordnung, die für den Fall, daß das Produkt aus innerer Verstärkung und Rückkopplungsfaktor kleiner als eins ist, als Verstärker und für den Fall, daß das Produkt aus innerer Verstärkung und Rückkopplungsfaktor größer als eins ist, als Schwellwertschalter wirkt, für eine stromgespeiste Differenzstufe (D), bei der der erste Ausgang (A1) der Differenzstufe (D) mit dem Emitter eines ersten Transistors (T1) und der zweite Ausgang (A2) mit dem Emitter eines zweiten Transistors (T2) verbunden ist und bei der zwei an die Versorgungsspannung angeschlossene Arbeitswiderstände (R1, R2) vorgesehen sind, von denen der erste Arbeitswiderstand (R1) an den Kollektor des ersten Transistors (T1) und die Basis des zweiten Transistors (T2) angeschlossen ist und der zweite Arbeitswiderstand (R2) an den Kollektor des zweiten Transistors (T2) und die Basis des ersten Transistors (T1) angeschlossen ist, wobei die Verbindungspunkte der Arbeitswiderstände (R1, R2) die Ausgänge der Schaltungsanordnung bilden, dadurch gekennzeichnet, daß ein Widerstand (R0) zwischen beide Ausgänge (A1, A2) der Differenzstufe (D) geschaltet ist, der beim Verstärker mit sinkendem Widerstandswert zur Erhöhung der Verstärkung oder beim Schwellwertschalter zum Einstellen des Abstandes der Umschaltpunkte, bei denen der Strom der Stromquelle von einem der Arbeitswiderstände (R1, R2) auf den anderen wechselt, dient.

2. Schaltungsanordnung nach Anspruch 1, dadurch gekennzeichnet, daß die Basis des ersten Transistors T1 über einen Widerstand R4 mit dem Kollektor des zweiten transistors T2 und die Basis des zweiten Transistors T2 über einen Widerstand R3 mit dem Kollektor des ersten Transistors T1 verbunden sind.

3. Schaltungsanordnung nach Anspruch 2, dadurch gekennzeichnet, daß jeweils zwischen Basis und Emitter des ersten bzw. zweiten Transistors T1, T2 ein Widerstand R5 bzw. R6 eingefügt ist.

4. Schaltungsanordnung nach einem der Ansprüche 1 oder 3, dadurch gekennzeichnet, daß den Basen des ersten und zweiten Transistors T1 bzw. T2 je ein als Emitterfolger arbeitender Transistor T3, T4 vorgeschaltet ist.

5. Schaltungsanordnung nach Anspruch 4, dadurch gekennzeichnet, daß die Basis des ersten Transistors T1 mit dem Emitter des vierten Transistors T4 und die Basis des zweiten Transistors T2 mit dem Emitter des dritten Transistors T3 verbunden sind, daß die Kollektoren des dritten und vierten Transistors T3 bzw. T4 mit der Versorgungsspannung verbunden sind und daß die Basis des dritten Transistors T3 mit dem Kollektor des ersten Transistors T1 und die Basis des vierten Transistors T4 mit dem Kollektor des zweiten Transistors T2 verbunden sind.

## Claims

1. Circuit arrangement which acts as amplifier in the event that the product of internal amplification and feedback factor is smaller than one, and as threshold switch in the event that the product of internal amplification and feedback factor is larger than one, for a current-fed differential stage (D) wherein the first output (A1) of the differential stage (D) is connected to the emitter of a first transistor (T1), and the second output (A2) to the emitter of a second transistor (T2), and wherein two operating resistors (R1, R2) connected to the supply voltage are provided, with the first operating resistor (R1) being connected to the collector of the first transistor (T1) and the base of the second transistor (T2), and the second operating resistor (R2) connected to the collector of the second transistor (T2) and the base of the first transistor (T1), and the connection points of the operating resistors (R1, R2) forming the outputs of the circuit arrangement, characterized in that there is connected between both outputs (A1, A2) of the differential stage (D) a resistor (R0) which serves in the case of the amplifier with decreasing resistance value to increase the amplification or in the case of the threshold switch to set the distance between the switch-over points at which the current of the current source changes from one of the operating resistors (R1, R2) to the other.

2. Circuit arrangement according to claim 1, characterized in that the base of the first transistor T1 is connected via a resistor R4 to the collector of the second transistor T2, and the base of the second transistor T2 via a resistor R3 to the collector of the first transistor T1.

3. Circuit arrangement according to claim 2, characterized in that a resistor R5 and R6, respectively, is inserted between base and emitter of the first and second transistor T1 and T2, respectively.

4. Circuit arrangement according to one of claims 1 or 3, characterized in that the bases of the first and second transistor T1 and T2, respectively, are each preceded by a transistor T3 and T4, respectively, operating as an emitter follower.

5. Circuit arrangement according to claim 4, characterized in that the base of the first transistor T1 is connected to the emitter of the fourth transistor T4, and the base of the second transistor T2 to the emitter of the third transistor T3, in that the collectors of the third and fourth transistor T3 and T4, respectively, are connected to the supply voltage, and in that the base of the third transistor T3 is connected to the collector of the first transistor T1, and the base of the fourth transistor T4 to the collector of the second transistor T2.

## Revendications

1. Montage agissant comme un amplificateur au cas où le produit de l'amplification interne et du taux de réinjection est plus petit que l'unité et comme un interrupteur à seuil au cas où le produit de l'amplification interne et du taux de réinjection est plus grand que l'unité, qui est destiné à un étage différenciateur (D) alimenté en courant et dont la première sortie (A1) est reliée à l'émetteur d'un premier transistor (T1) du montage et la deuxième sortie (A2) est reliée à l'émetteur d'un second transistor (T2) du montage, lequel comprend en outre deux résistances de charge (R1, R2) reliées à la tension d'alimentation, dont la première (R1) est reliée au collecteur du premier transistor (T1) et à la base du second transistor (T2) et dont la deuxième résistance de charge (R2) est reliée au collecteur du second transistor (T2) et à la base du premier transistor (T1), les points de liaison des résistances de charge (R1, R2) formant les sorties du montage, caractérisé en ce qu'il comprend une résistance (R0) branchée entre les deux sorties (A1, A2) de l'étage différenciateur (D), qui sert dans l'amplificateur à augmenter le gain par abaissement de sa valeur de résistance ou qui sert dans l'interrupteur à seuil à régler l'intervalle entre les points de commutation où le courant fourni par la source de courant passe d'une des résistances de charge (R1, R2) à l'autre.

2. Montage selon la revendication 1, caractérisé en ce que la base du permier transistor (T1) est reliée à travers une résistance (R4) au collecteur du second transistor (T2) et la base du second transistor (T2) est reliée à travers une résistance (R3) au collecteur du premier transistor (T1).

3. Montage selon la revendication 2, caractérisé en ce qu'une résistance (R5 ou R6) est insérée entre la base et l'émetteur du premier (T1) et du second transistor (T2).

4. Montage selon la revendication 1 ou 3, caractérisé en ce qu'un transistor (T3, T4) travaillant comme émetteur-suiveur est monté en série avec la base du premier (T1) et du second transistors (T2).

5. Montage selon la revendication 4, caractérisé en ce que la base du premier transistor (T1) est reliée à l'émetteur du quatrième transistor (T4) et la base du second transistor (T2) est reliée à l'émetteur du troisième transistor (T3), que les collecteurs des troisième (T3) et quatrième transistors (T4) sont reliés à la tension d'alimentation et que la base du troisième transistor (T3) est reliée au collecteur du premier transistor (T1) et la base du quatrième transistor (T4) est reliée au collecteur du second transistor (T2).

Fig.1

Fig.2

Fig. 3